(19) Europäisches Patentamt
European Patent Office
Office européen des brevets

(11) EP 2 525 628 A1

(12) # EUROPEAN PATENT APPLICATION
published in accordance with Art. 153(4) EPC

(43) Date of publication:
**21.11.2012 Bulletin 2012/47**

(21) Application number: **11732928.4**

(22) Date of filing: **13.01.2011**

(51) Int Cl.:
***H05B 33/26*** *(2006.01)* ***C08G 61/12*** *(2006.01)*
***H01L 51/50*** *(2006.01)*

(86) International application number:
**PCT/JP2011/050444**

(87) International publication number:
**WO 2011/087058 (21.07.2011 Gazette 2011/29)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.01.2010 JP 2010007301**

(71) Applicant: **Sumitomo Chemical Company, Limited
Tokyo 104-8260 (JP)**

(72) Inventor: **YAMAUCHI, Shohgo
Tsukuba-shi
Ibaraki 305-0005 (JP)**

(74) Representative: **Jackson, Martin Peter
J A Kemp
14 South Square
Gray's Inn
London WC1R 5JJ (GB)**

(54) **POLYMER LIGHT EMITTING ELEMENT**

(57) The problem to be solved of the present invention is to improve luminance level of a polymer light-emitting device even when it is driven at a low voltage. Means for solving the problem is a polymer light-emitting device comprising a cathode, an anode, and a functional layer containing a polymer compound and a light-emitting layer containing an organic polymer light-emitting compound arranged between the cathode and the anode, wherein the cathode comprises a first electrode layer and a second electrode layer in this order from the light-emitting layer side, the first electrode layer comprises a first material and a second material, the first material comprises a material which contains one or more compounds selected from the group consisting of sodium fluoride, potassium fluoride, cesium fluoride, rubidium fluoride and a carbonate of an alkaline earth metal, and the second material comprises a substance which has a reduction action on the first material.

1

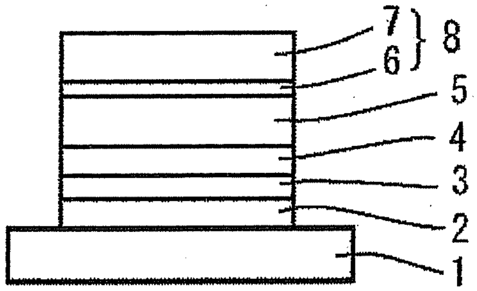




Printed by Jouve, 75001 PARIS (FR)

## Description

### TECHNICAL FIELD

The present invention relates to a polymer light-emitting device, and particularly to a polymer light-emitting device that shows a high luminance when driven at a low voltage.

### BACKGROUND ART

An organic light-emitting device is a device configured to include a cathode, an anode and a layer comprising an organic light-emitting compound arranged between the cathode and the anode. In the organic light-emitting device, electrons supplied from the cathode combine with holes supplied from the anode, and light is emitted as a result of the combination. Energy generated thereby is taken out of the device in the form of light.
As an example of the organic light-emitting device, a device in which the organic light-emitting compound is an organic polymer light-emitting compound (hereinafter, such a device is referred to as a "polymer light-emitting device") is known. The polymer light-emitting device is advantageous for enlargement of the area thereof and reduction in cost since the light-emitting layer thereof can be conveniently formed by wet coating.
In the field of organic light-emitting devices, there is a pending problem to lower driving voltage and improve luminance. In order to solve this problem, it is effective to improve efficiency of injecting electrons into a layer containing the organic light-emitting compound.
There have been conventionally investigated various cathode structures for the purpose of facilitating injection of electrons into a light-emitting layer. For example, Patent Document 1 describes that a cathode used for an organic light-emitting device is formed into a two-layer structure having a metal compound layer and a metal layer. As the metal compound and the metal, lithium fluoride and aluminum are used, respectively.
Further, Patent Document 2 describes a cathode including a reduction reaction part formed by reduction reaction of a metal compound of an alkali metal or an alkaline earth metal with a reducing agent, and a transparent conductive film disposed on the reduction reaction part.

### BACKGROUND DOCUMENTS

### [PATENT DOCUMENTS]

Patent Document 1: Japanese Patent Laid-open Publication No. H10(1998)-74586
Patent Document 2: Japanese Patent Laid-open Publication No. 2004-311403

### DISCLOSURE OF THE INVENTION

### PROBLEMS TO BE SOLVED BY THE INVENTION

However, though polymer light-emitting devices using such conventional cathode structures, particularly in the case of being driven at a low voltage, there was a problem that the luminance is not sufficient.
It is an object of the present invention to provide a polymer light-emitting device that shows a high luminance in the case of being driven at a low voltage.

### MEANS FOR SOLVING THE PROBLEMS

That is, the present invention provides a polymer light-emitting device comprising a cathode, an anode, and a functional layer containing a polymer compound and a light-emitting layer containing an organic polymer light-emitting compound arranged between the cathode and the anode, wherein
the cathode comprises a first electrode layer and a second electrode layer in this order from the light-emitting layer side,
the first electrode layer comprises a first material and a second material,
the first material is a material which comprises one or more compounds selected from the group consisting of sodium fluoride, potassium fluoride, cesium fluoride, rubidium fluoride and carbonates of alkaline earth metals, and
the second material is a substance which has a reducing action on the first material.
In one embodiment, the first electrode layer consists of the first material and the second material.
In one embodiment, the first material is sodium fluoride or potassium fluoride and the second material is magnesium, calcium or aluminum.

In one embodiment, the first material is sodium fluoride and the second material is magnesium.

In one embodiment, the first material is sodium carbonate or potassium carbonate and the second material is magnesium, calcium or aluminum.

In one embodiment, the proportion of the number of moles of the second material to the total number of moles of the materials contained in the first electrode layer is more than 0.20 and not more than 0.60.

In one embodiment, the functional layer contains a polymer compound including a repeating unit represented by the formula:

[Chem. 1]

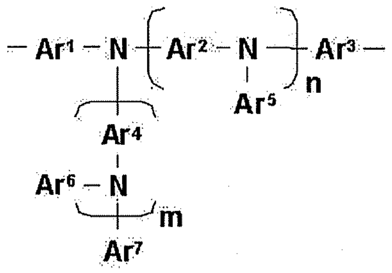

(1)

wherein $Ar^1$, $Ar^2$, $Ar^3$ and $Ar^4$ are the same or different and each represent an arylene group optionally having a substituent or a divalent heterocyclic group optionally having a substituent, $Ar^5$, $Ar^6$ and $Ar^7$ each represent an aryl group optionally having a substituent or a monovalent heterocyclic group optionally having a substituent, n and m are the same or different and each represent 0 or 1, and when n is 0, a carbon atom contained in $Ar^1$ and a carbon atom contained in $Ar^3$ may be bound to each other either directly or via an oxygen atom or a sulfur atom.

In one embodiment, the second electrode layer comprises silver.

EFFECTS OF THE INVENTION

The polymer light-emitting device of the present invention is very useful industrially since it has a low driving voltage to start light emission and emits light at high luminance even when it is driven at a low voltage.

BRIEF DESCRIPTION OF THE DRAWINGS

[Fig. 1] Fig. 1 is a schematic sectional view showing the structure of an organic electroluminescence device (organic EL device), which is one embodiment of the present invention.

EMBODIMENT FOR CARRYING OUT THE INVENTION

1. Structure of Device

A polymer light-emitting device of the present invention includes a cathode, an anode, and a light-emitting layer containing an organic polymer light-emitting compound arranged between the cathode and the anode. Further, the polymer light-emitting device of the present invention further includes at least one functional layer containing a polymer compound arranged between the cathode and the anode.

Examples of the functional layer include a hole injection layer, a hole transporting layer, an electron injection layer, an electron transporting layer, a hole blocking layer, and an interlayer. For example, from the viewpoint of lowering driving voltage when light is emitted at a luminance of 1000 cd/$m^2$ and from the viewpoint of lengthening the luminance half-decay lifetime, it is preferred that the polymer light-emitting device has the functional layer between the anode and the light-emitting layer, and it is more preferred that the functional layer is the hole transporting layer. In this case, a hole transporting compound contained in the hole transporting layer is preferably an organic polymer compound having a repeating unit represented by the formula (1).

As described above, the polymer light-emitting device of the present invention includes the cathode and the anode, and includes at least the functional layer and the light-emitting layer arranged between the cathode and the anode, and in addition to these, the polymer light-emitting device can further include an optional constituent.

For example, when the functional layer is the hole transporting layer, the polymer light-emitting device can

include the hole injection layer between the anode and the hole transporting layer, and can further include the interlayer between the light-emitting layer and the hole injection layer (when the hole injection layer is present) or the anode (when the hole injection layer is absent).

On the other hand, the polymer light-emitting device can include the electron injection layer between the cathode and the light-emitting layer, and can further include the electron transporting layer or the hole blocking layer or both of the electron transporting layer and the hole blocking layer between the light-emitting layer and the electron injection layer (when the electron injection layer is present) or the cathode (when the electron injection layer is absent).

Here, the anode is a member which supplies holes to the hole injection layer, the hole transporting layer, the interlayer, the light-emitting layer and the like, and the cathode is a member which supplies electrons to the electron injection layer, the electron transporting layer, the hole blocking layer, the light-emitting layer and the like.

The light-emitting layer refers to a layer having a function capable of being injected with holes from a layer adjacent to an anode and being injected with electrons from a layer adjacent to a cathode in applying an electrical field, a function of moving injected charges (electrons and holes) by a force of the electrical field, and a function of providing a field for binding between the electrons and the holes and leading this binding to light emission.

The electron injection layer refers to a layer having a function capable of being injected with electrons from the cathode. The electron transporting layer refer to a layer having any one of a function of transporting electrons and a function of damming holes being injected from the anode. Further, the hole blocking layer refers to a layer having a function of primarily damming holes injected from the anode, and further having either of a function of being injected with electrons from the cathode or a function of transporting electrons, as required.

The hole injection layer refers to a layer having a function of being injected with holes from the anode. The hole transporting layer refers to a layer having any one of a function of transporting holes, a function of supplying holes to the light-emitting layer and a function of damming electrons being injected from the cathode. Further, the interlayer has at least one of a function of being injected with holes from the anode, a function of transporting holes, a function of supplying holes to the light-emitting layer and a function of damming electrons being injected from the cathode, is usually arranged at a position adjacent to the light-emitting layer, and has a role (or a function) of isolating the light-emitting layer from the anode, or the light-emitting layer from the hole injection layer or the hole transporting layer.

Here, the electron transporting layer and the hole transporting layer are collectively called charge transporting layers. Further, the electron injection layer and the hole injection layer are collectively called charge injection layers.

The polymer light-emitting device of the present invention can be usually configured to further include a substrate as an optional constituent and to dispose the cathode, the anode, the functional layer and the light-emitting layer on the surface of the substrate, and other optional constituents as required.

In an aspect of the polymer light-emitting device of the present invention, usually, the anode is disposed on the substrate, and as an upper layer thereof, the functional layer and the light-emitting layer are laminated, and as an additional upper layer thereof, the cathode is laminated. As a variation of the aspect, the cathode may be disposed on the substrate and the anode may be disposed as the upper layer of the functional layer and the light-emitting layer.

As another variation, it is also possible to employ a polymer light-emitting device of any of the so-called bottom emission type to emit light from a substrate side, the so-called top emission type to emit light from a side opposite to the substrate side and a both-side light emission type. As further variation, a layer having other functions such as optional protective film, buffer film, reflective layer and the like may be disposed. The polymer light-emitting device is further covered with a sealing film or a sealing substrate to form a polymer light-emitting apparatus in which the polymer light-emitting device is isolated from the outside air.

For example, the polymer light-emitting device of the present invention can have the following layer structure (a), or can have a layer structure in which one or more layers of the hole injection layer, the hole transporting layer, the interlayer, the hole blocking layer, the electron transporting layer and the electron injection layer are omitted from the layer structure (a). Further, in the polymer light-emitting device of the present invention, the functional layer functions as any one layer of the hole injection layer, the hole transporting layer, the interlayer, the hole blocking layer, the electron transporting layer and the electron injection layer.

(a) anode-hole injection layer-(hole transporting layer and/or interlayer)-light-emitting layer-(hole blocking layer and/or electron transporting layer)-electron injection layer-cathode

Here, the symbol "-" means the matter that both layers shown on the both sides of the symbol "-" are adjacently laminated one on one.

The term "(hole transporting layer and/or interlayer)" means a layer configuration of any of a layer composed only of the hole transporting layer, a layer composed only of the interlayer, a layer configuration of hole transporting layer-interlayer, a layer configuration of interlayer-hole transporting layer, or the other arbitrary layer configuration including one or more hole transporting layers and interlayers, respectively.

The term "(hole blocking layer and/or electron transporting layer)" means a layer configuration of any of a layer composed only of the hole blocking layer, a layer composed only of the electron transporting layer, a layer configuration of hole blocking layer-electron transporting layer, a layer configuration of electron transporting layer-hole blocking layer,

or the other arbitrary layer configuration including one or more hole blocking layers and electron transporting layers, respectively. In the following, layer configurations will be described similarly to these descriptions.

Moreover, the polymer light-emitting device of the present invention can have two light-emitting layers in one laminate structure. In this case, the polymer light-emitting device can have the following layer structure (b), or can have a layer structure in which one or more layers of the hole injection layer, the hole transporting layer, the interlayer, the hole blocking layer, the electron transporting layer, the electron injection layer and the electrode are omitted from the layer structure (b).

(b) anode-hole injection layer-(hole transporting layer and/or interlayer)-light-emitting layer-(hole blocking layer and/or electron transporting layer)-electron injection layer-electrode-hole injection layer-(hole transporting layer and/or interlayer)-light-emitting layer-(hole blocking layer and/or electron transporting layer)-electron injection layer-cathode

Moreover, the polymer light-emitting device of the present invention can have three or more light-emitting layers in one laminate structure. In this case, the polymer light-emitting device can have the following layer structure (c), or can have a layer structure in which one or more layers of the hole injection layer, the hole transporting layer, the interlayer, the hole blocking layer, the electron transporting layer, the electron injection layer and the electrode are omitted from the layer structure (c).

(c) anode-hole injection layer-(hole transporting layer and/or interlayer)-light-emitting layer-(hole blocking layer and/or electron transporting layer)-electron injection layer-repeating unit A-repeating unit A...-cathode

Here, the "repeating unit A" represents a unit of the layer structure of electrode-hole injection layer-(hole transporting layer and/or interlayer)-light-emitting layer-(hole blocking layer and/or electron transporting layer)-electron injection layer.

Specific examples of the preferable layer structure of the polymer light-emitting device of the present invention include the followings.

(e) anode-hole transporting layer-light-emitting layer-cathode
(f) anode-light-emitting layer-electron transporting layer-cathode
(g) anode-hole transporting layer-light-emitting layer-electron transporting layer-cathode.

Further, for each of these structures, a structure, in which the interlayer is disposed at a position adjacent to the light-emitting layer between the light-emitting layer and the anode, can be recited as one example of a preferred layer structure. That is, the following structures (d') to (g') are provided as examples.

(d') anode-interlayer-light-emitting layer-cathode
(e') anode-hole transporting layer-interlayer-light-emitting layer-cathode
(f') anode-interlayer-light-emitting layer-electron transporting layer-cathode
(g') anode-hole transporting layer-interlayer-light-emitting layer-electron transporting layer-cathode.

In the present invention, examples of a polymer light-emitting device including a charge injection layer (electron injection layer or hole injection layer) include a polymer light-emitting device in which the charge injection layer is disposed at a position adjacent to the cathode, and a polymer light-emitting device in which the charge injection layer is disposed at a position adjacent to the anode. Specific examples thereof include the following structures (h) to (s).

(h) anode-charge injection layer-light-emitting layer-cathode
(i) anode-light-emitting layer-charge injection layer-cathode
(j) anode-charge injection layer-light-emitting layer-charge injection layer-cathode
(k) anode-charge injection layer-hole transporting layer-light-emitting layer-cathode
(1) anode-hole transporting layer-light-emitting layer-charge injection layer-cathode
(m) anode-charge injection layer-hole transporting layer-light-emitting layer-charge injection layer-cathode
(n) anode-charge injection layer-light-emitting layer-electron transporting layer-cathode
(o) anode-light-emitting layer-electron transporting layer-charge injection layer-cathode
(p) anode-charge injection layer-light-emitting layer-electron transporting layer-charge injection layer-cathode
(q) anode-charge injection layer-hole transporting layer-light-emitting layer-electron transporting layer-cathode
(r) anode-hole transporting layer-light-emitting layer-electron transporting layer-charge injection layer-cathode
(s) anode-charge injection layer-hole transporting layer-light-emitting layer-electron transporting layer-electron injection layer-cathode

Further, for each of these layer structures, a structure, in which the interlayer is disposed at a position adjacent to the light-emitting layer between the light-emitting layer and the anode, similarly to the above-mentioned (d') to (g'), can be recited as one example of a preferred layer structure. In this case, the interlayer may also serve as the hole

injection layer and/or the hole transporting layer.

The polymer light-emitting device of the present invention may further include an insulating layer at a position adjacent to the electrode for the purpose of improving adhesion to the electrode or improving injection of the charge (i.e., hole or electron) from the electrode, or may include a thin buffer layer located at the interface between the charge transporting layer (i.e., hole transporting layer or electron transporting layer) and another layer or between the light-emitting layer and another layer for the purpose of improving adhesion of the interface or preventing material mixing.

The order and the number of layers to be laminated, and thickness of each layer can be appropriately determined in consideration of luminous efficiency or a device lifetime.

2. Materials Composing Layers of Device

Next, materials of and methods for forming layers composing the polymer light-emitting device of the present invention will be described more specifically.

<Cathode>

In the present invention, the cathode is disposed directly on the light-emitting layer or disposed with any layer interposed between the cathode and the light-emitting layer. The cathode is composed of two or more layers. Those layers may be referred to as a first electrode layer, a second electrode layer, a third electrode layer (in the case where three layers or more are present) from a side close to the light-emitting layer.

In the present invention, the first electrode layer comprises a first material and a second material. The material of the first electrode is any of sodium fluoride, potassium fluoride, cesium fluoride, rubidium fluoride and a carbonate of an alkaline earth metal and the second material comprises a substance which has a reduction action on the first material.

Here, the presence or absence and the level of the reducing power between the materials can be estimated, for example, from bond dissociation energy ($\Delta rH°$) between compounds. That is, in the reduction reaction between the first material contained in the first layer and the second material contained in the first layer, if $\Delta rH°$ is a positive value, it can be said that the second material has a reducing action (reducing power) on the first material. Even though $\Delta rH°$ is negative, but when the absolute value thereof is less than 20 kJ/mol, the second material, which became thermally active during a process for film-forming a cathode, such as a vacuum deposition method, can have a reducing action (reducing power) on the first material. The bond dissociation energy can be obtained with reference to, for example, "Electrochemical Handbook (5th edition)" (Maruzen Publishing Co., Ltd., 2000) and "Thermodynamic Database MALT" (Kagaku Gijutsu-Sha, 1992).

Specific examples of the alkali metal fluoride contained in the first electrode layer include a material selected from the group consisting of sodium fluoride (NaF), potassium fluoride (KF), rubidium fluoride (RbF), cesium fluoride (CsF) and the mixture thereof. Among these, NaF, KF is preferable from the aspect of the stability during the production process.

Specific examples of the alkali metal carbonate contained in the first electrode layer include a material selected from the group consisting of sodium carbonate ($Na_2CO_3$), potassium carbonate ($K_2CO_3$), rubidium carbonate ($Rb_2CO_3$), cesium carbonate ($CS_2CO_3$) and the mixture thereof. Among these, $Na_2CO_3$, $K_2CO_3$ is preferable from the aspect of the stability during the production process.

Specific examples of the substance which has a reduction action contained in the first electrode layer include magnesium (Mg), calcium (Ca), aluminum (Al). Among these, Mg is preferable from the aspect of the stability during the production process.

An combination of the first material and the second material which composes the first electrode layer includes NaF:Mg, NaF:Ca, NaF:Al, $Na_2CO_3$:Mg, $Na_2CO_3$:Ca, $Na_2CO_3$:Al, KF:Mg, KF:Ca, KF:Al, $K_2CO_3$:Mg, $K_2CO_3$:Ca, $K_2CO_3$:Al. In the above combination, the material shown at the left side is the first material and the material shown at the right side is the second material. The symbol ":" means that the substance is a mixture. Among the above combination, NaF:Mg is preferable from the aspect of the stability during the production process.

With respect to the mixing ratio of the first material and the second material, it is preferable that the molar ratio (Dr) of the second material to the sum of the first and the second materials satisfies the following expression:

[Math. 1]

$$20\% < Dr \leqq 60\%$$

(Expression 1)

and more preferable the following expression.

[Math. 2]

$$30\% \leqq Dr \leqq 40\%$$

from a viewpoint of the driving voltage. When Dr deviates from the above range, there may cause a case where it fails to emit light at high luminance when it is driven at a low voltage, since the first material is not sufficiently reduced.

In the cathode of the present invention, the second electrode layer is disposed on the first electrode layer. The second electrode layer comprises an electroconductive compound, and on the second electrode layer, a layer comprising an electroconductive compound may be further disposed. Specific examples of the electroconductive compound contained in the second electrode layer and the electroconductive compound contained in the layer which may be disposed on the second electrode layer include metals with low resistance, such as gold, silver, copper, aluminum, chromium, tin, lead, nickel, and titanium, and alloys containing these metals; electroconductive metal oxides, such as tin oxide, zinc oxide, indium oxide, indium tin oxide (ITO), indium zinc oxide (IZO), and molybdenum oxide; and mixtures of these electroconductive metal oxides and metals. It is preferable that the electroconductive compounds contained in the second electrode layer and in the layer disposed on the second electrode layer have a low optical absorption coefficient. From the viewpoint of low optical absorption coefficient, silver, ITO is preferable for the electroconductive compound contained in the second electrode layer and the electroconductive compound contained in the layer disposed on the second electrode layer. The electroconductive compound contained in the layer disposed on the second electrode layer may be the same or different from the electroconductive compound contained in the second electrode layer. Each of the second electrode layer and the layer disposed on the second electrode layer containing the electroconductive compound may contain a substance other than the electroconductive compound, for example, an organic substance in an amount which does not significantly deteriorate the electroconductivity. However, the upper limit of the content is typically a value where the sheet resistance of the electrode layer is not more than about 10 ohm/square (ohms per square).

A method for preparing the cathode is not particularly limited and publicly known methods can be employed. Examples of such publicly known methods include a vacuum deposition method, a sputtering method, and an ion plating method. When metals, metal oxides, metal fluorides, or metal carbonates are used for the cathode, a vacuum deposition method is often used, and when electroconductive metal oxides, such as metal oxides having a high boiling point, composite metal oxides, and indium tin oxide (ITO), are used, a sputtering method and an ion plating method are often used. When a composition of these materials mixed with different materials is formed into a film for the cathode, a co-deposition method, a sputtering method, an ion plating method or the like is used. Particularly, when a composition containing a low molecular organic substance mixed with a metal, a metal oxide, a metal fluoride or a metal carbonate is formed into a film for the cathode, the co-deposition method is suitable.

When a light-transmitting electrode is used as the cathode in the polymer light-emitting device of the present invention, visible light transmittance of the second electrode layer and the layer disposed on the second electrode layer is preferably 40% or more, and more preferably 50% or more. Such a visible light transmittance is attained by using, as the electroconductive compound contained in the second electrode layer and the layer disposed on the second electrode layer, a transparent electroconductive metal oxide, such as indium tin oxide (ITO), indium zinc oxide (IZO) or molybdenum oxide, or by maintaining film thickness of the second electrode layer and the layer disposed on the second electrode layer, which uses a metal with low resistance, such as gold, silver, copper, aluminum, chromium, tin, and lead, and an alloy containing these metals, below 30 nm.

Further, an antireflection layer may be disposed on an outermost layer of the cathode for the purpose of improving transmittance of the cathode side. As a material used in the antireflection layer, a material having a refractive index (n) of about 1.8 to 3.0 is preferred, and examples of the material include ZnS, ZnSe, and $WO_3$. Film thickness of the antireflection layer varies depending on the combination of the materials, and is usually in the range of 10 nm to 150 nm.

<Substrate>

The material of the substrate composing the polymer light-emitting device of the present invention may be a substance which does not chemically vary when the electrode is formed and a layer of an organic substance is formed, and for example, glass, plastic, a polymer film, a metal film, a silicon substrate, or a laminate thereof is used. As the substrate, commercialized products are available, or the substrate can be produced by a publicly known method.
When the polymer light-emitting device of the present invention composes pixels of a display device, a circuit for driving pixels may be disposed on the substrate, or a planarizing film may be disposed on the driving circuit. When the planarizing film is disposed, it is preferred that an average roughness (Ra) at the center line on the planarizing film satisfies the following expression:
[Math. 3]

$$Ra < 10 nm$$

Ra can be measured according to Japanese Industrial Standards (JIS) JIS-B0601-2001 by reference to JIS-B0651 to JIS-B0656 and JIS-B0671-1, etc.

<Anode>

In the anode composing the polymer light-emitting device of the present invention, it is preferred that work function of the surface on the light-emitting layer side of the anode is 4.0 eV or more from the viewpoint of the ability to supply a hole to an organic semiconductor material to be used in the hole injection layer, the hole transporting layer, the interlayer, the light-emitting layer and the like.
For example, electroconductive compounds, such as metals, alloys, metal oxides and metal sulfides, or mixtures thereof can be used for the material of the anode. Specific examples of the electroconductive compounds include electroconductive metal oxides, such as tin oxide, zinc oxide, indium oxide, indium tin oxide (ITO), indium zinc oxide (IZO), molybdenum oxide; or metals such as gold, silver, chromium, nickel; and mixtures of these electroconductive metal oxides and metals.
The anode may have a single-layer structure composed of one or more of these materials, or may have a multilayer structure composed of a plurality of layers having the same composition or different compositions. When the anode has a multilayer structure, a material having a work function of 4.0 eV or more is preferably used for the outermost surface layer of the light-emitting layer side of the anode.
A method for preparing the anode is not particularly limited and publicly known methods can be employed. Examples thereof include a vacuum deposition method, a sputtering method, an ion plating method, and a plating method.
The film thickness of the anode is usually 10 nm to 10 μm, and preferably 50 nm to 500 nm. Further, an average roughness (Ra) at the center line on the surface on the light-emitting layer side of the anode preferably satisfies the following expression:
[Math. 4]

$$Ra < 10 nm$$

and more preferably satisfies the following expression:
[Math. 5]

$$Ra < 5 nm$$

from the viewpoint of preventing defective electrical connection such as short circuit.

Moreover, after the anode is prepared by the above-mentioned method, it may be surface-treated with UV ozone, a silane coupling agent, a solution containing an electron-accepting compound, such as 2,3,5,6-tetrafluoro-7,7,8,8-tetracyanoquinodimethane. By the surface treatment, electrical connection to the layer in contact with the anode is improved.

When the anode is used as a light-reflecting electrode in the polymer light-emitting device of the present invention, the anode preferably has a multilayer structure in which a light-reflecting layer composed of a highly light-reflecting metal is combined with a high work function material layer containing a material having a work function of 4.0 eV or more. Specific examples of such configuration of the anode include:

(i) Ag-$MoO_3$,
(ii) (Ag-Pd-Cu alloy)-(ITO and/or IZO),
(iii) (Al-Nd alloy)-(ITO and/or IZO),
(iv) (Mo-Cr alloy)-(ITO and/or IZO), and
(v) (Ag-Pd-Cu alloy)-(ITO and/or IZO)-$MoO_3$.

In order to attain sufficient light reflectance, the film thickness of the layer of highly light-reflecting metal, such as Al, Ag, an Al alloy, an Ag alloy, and a Cr alloy is preferably 50 nm or more, and more preferably 80 nm or more. The film thickness of the layer of the high work function material, such as ITO, IZO, and $MoO_3$ is usually in the range of 5 to 500 nm.

<Hole Injection Layer>

Examples of the materials composing the hole injection layer in the polymer light-emitting device of the present invention include carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, starburst type amines, phthalocyanine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidyne-based compounds, porphyrin-based compounds, polysilane-based compounds, poly(N-vinylcarbazole) derivatives, organic silane derivatives, and polymers containing these. Further, examples of materials composing the hole injection layer also include electroconductive metal oxides, such as vanadium oxide, tantalum oxide, tungsten oxide, molybdenum oxide, ruthenium oxide, and aluminum oxide; electroconductive polymers and oligomers, such as polyaniline, aniline-based copolymers, a thiophene oligomer, and polythiophene; organic electroconductive materials, such as poly(3,4-ethylenedioxythiophene)-polystyrenesulfonic acid, and polypyrrole, and polymers containing these; and amorphous carbon. Moreover, accepting organic compounds, such as tetracyanoquinodimethane derivatives (e.g., 2,3,5,6-tetrafluoro-7,7,8,8-tetracyanoquinodimethane), 1,4-naphthoquinone derivatives, diphenoquinone derivatives, and polynitro compounds; and silane coupling agents, such as octadecyltrimethoxysilane can be suitably used.

The above-mentioned materials may be a single component, or may be a composition including a plurality of components. Further, the hole injection layer may have a single-layer structure composed of one or more of the above-mentioned materials, or may have a multilayer structure composed of a plurality of layers having the same composition or different compositions. Further, the materials, which are recited as the materials capable of being used in a hole transporting layer or an interlayer, can also be used in the hole injection layer.

A method for preparing the hole injection layer is not particularly limited and publicly known methods can be employed. Examples of the preparation methods include a vacuum deposition method, a sputtering method, and an ion plating method for the inorganic compound materials, and include a vacuum deposition method, transfer methods, such as laser transfer, and thermal transfer, and methods based on film formation from a solution (a mixed solution of a low molecular organic material and a polymer binder may be employed) for low molecular organic materials. Further, in the case of polymer organic materials, examples of the preparation methods include methods based on film formation from a solution.

The hole injection layer can be prepared by use of the vacuum deposition method when the hole injection material is a low molecular compound, such as a pyrazoline derivative, an arylamine derivative, a stilbene derivative, and a triphenyldiamine derivative.

Further, the hole injection layer can also be formed by use of a mixed solution in which a polymer compound binder and these low molecular hole injection compound are dispersed. As the polymer compound binder mixed in the mixed solution, a substance which does not extremely interfere with charge transfer is preferable, and a substance which does not have intense absorption of visible light is suitably used. Specific examples thereof include poly(N-vinylcarbazole), polyaniline or derivatives thereof, polythiophene or derivatives thereof, poly(p-phenylene vinylene) or derivatives thereof, poly(2,5-thienylene vinylene) or derivatives thereof, polycarbonate, polyacrylate, polymethyl acrylate, polymethyl methacrylate, polystyrene, polyvinyl chloride, and polysiloxane.

A solvent for use in forming a film from a solution is not particularly limited as long as it is a solvent which dissolves the hole injection material. Examples of the solvent include water; chlorine-based solvents, such as chloroform, methylene chloride, and dichloroethane; ether-based solvents, such as tetrahydrofuran and the like; aromatic hydrocarbon-based solvents, such as toluene, xylene; ketone-based solvents, such as acetone, and methyl ethyl ketone; and ester-based solvents, such as ethyl acetate, butyl acetate, and ethyl cellosolve acetate.

As the method for forming a film from a solution, application methods which include coating methods, such as a spin coating method from a solution, a casting method, a microgravure coating method, a bar coating method, a roller coating method, a wire-bar coating method, a dip coating method, a slit coating method, a capillary coating method, a spray coating method, and a nozzle coating method; and printing methods, such as a gravure printing method, a screen printing method, a flexo printing method, an offset printing method, a reversal printing method, and an ink-jet printing method, can be used. The printing method such as a gravure printing method, a screen printing method, a flexo printing method, an offset printing method, a reversal printing method, and an ink-jet printing method; and the nozzle coating method are preferable in that pattern forming is easy.

When an organic compound layer, such as a hole transporting layer, an interlayer, and a light-emitting layer, is formed following the hole injection layer, particularly when both layers are formed by an application method, the layer applied first may be dissolved in the solvent contained in the solution of the layer to be applied later, resulting in failure in preparation of a laminate structure. In this case, it is possible to employ a method of making the lower layer insoluble in the solvent. Examples of the method of making a layer insoluble in the solvent include a method of crosslinking by attaching a crosslinking group to the polymer compound itself, a method of crosslinking by mixing a low molecular compound containing a crosslinkable group having an aromatic ring typified by aromatic bisazide with a crosslinking agent, a method of crosslinking by mixing a low molecular compound containing a crosslinkable group not having an aromatic ring typified by an acrylate group with a crosslinking agent, a method of making the lower layer insoluble in an organic solvent to be used for preparation of the upper layer by exposing the lower layer to ultraviolet light, and a method of making the lower layer insoluble in an organic solvent to be used for preparation of the upper layer by heating the lower layer. Heating temperature in heating the lower layer is usually about 100°C to 300°C, and heating time is usually about 1 minute to 1 hour.

As another method of laminating without dissolving the lower layer by a method other than crosslinking, there is a method of using solutions having different polarities for layers adjacent to each other, and examples thereof include a method in which a water-soluble polymer compound is used for the lower layer, an oil-soluble polymer compound is used for the upper layer, thereby making the lower layer not soluble even if the upper layer material is applied.

The film thickness of the hole injection layer varies in an optimal value depending on a material to be used, and may be selected in such a way that driving voltage and luminous efficiency are moderate, but it is necessary to select such a thickness that at least no pinhole is produced. That the thickness is too large is not preferred because if so, the driving voltage of the device becomes high. Therefore, the film thickness of the hole injection layer is, for example, 1 nm to 1 μm, preferably 2 nm to 500 nm, and moreover preferably 10 nm to 100 nm.

<Hole Transporting Layer or Interlayer>

Examples of materials composing the hole transporting layer or the interlayer in the polymer light-emitting device of the present invention include carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidyne-based compounds, porphyrin-based compounds, polysilane-based compounds, poly(N-vinylcarbazole) derivatives, organic silane derivatives, and polymer compounds containing these structures. Further, examples of materials composing the hole transporting layer or the interlayer also include electroconductive polymers and oligomers, such as aniline-based copolymers, thiophene oligomers, and polythiophene; and organic electroconductive materials, such as polypyrrole.

The above-mentioned materials may be a single component, or may be a composition including a plurality of components. Further, the hole transporting layer or the interlayer may have a single-layer structure composed of one or more of the above-mentioned materials, or may have a multilayer structure composed of a plurality of layers having the same composition or different compositions. Further, the materials, which are recited as the materials capable of being used in the hole injection layer, can also be used as the hole injection layer.

Specifically, compounds disclosed in, for example, Japanese Patent Laid-open Publication No. S63(1988)-70257, Japanese Patent Laid-open Publication No. S63(1988)-175860, Japanese Patent Laid-open Publication No. H2 (1990)-135359, Japanese Patent Laid-open Publication No. H2(1990)-135361, Japanese Patent Laid-open Publication No. H2(1990)-209988, Japanese Patent Laid-open Publication No. H3(1991)-37992, Japanese Patent Laid-open Publication No. H3(1991)-152184, Japanese Patent Laid-open Publication No. H5(1993)-263073, Japanese Patent Laid-open Publication No. H6(1994)-1972, International Publication WO 2005/52027, and Japanese Patent Laid-open Publication No. 2006-295203, can be used as a material of the hole transporting layer or the interlayer. Among these, the polymer containing a repeating unit including a structure of an aromatic tertiary amine compound is suitably used.

The reason for this is that the polymer light-emitting device emits light at particularly high luminance even when it is driven at a low voltage by combining the cathode having the structure of the present invention with the hole transporting layer including the polymer compound containing a repeating unit including a structure of an aromatic tertiary amine compound.

Examples of the repeating units including a structure of an aromatic tertiary amine compound include the repeating unit represented by the above formula (1).

In the formula (1), a hydrogen atom on the aromatic ring may be substituted with a substituent selected from halogen atoms, alkyl groups, alkyloxy groups, alkylthio groups, aryl groups, aryloxy groups, arylthio groups, arylalkyl groups, arylalkyloxy groups, arylalkylthio groups, alkenyl groups, alkynyl groups, arylalkenyl groups, arylalkynyl groups, acyl groups, acyloxy groups, amide groups, acid imide groups, imine residues, substituted amino groups, substituted silyl groups, substituted silyloxy groups, substituted silylthio groups, substituted silylamino groups, cyano groups, nitro groups, monovalent heterocyclic groups, heteroaryloxy groups, heteroarylthio groups, alkyloxycarbonyl groups, aryloxycarbonyl groups, arylalkyloxycarbonyl groups, heteroaryloxycarbonyl groups, carboxyl groups and so on. Further, the substituent may be a crosslinkable group, such as a vinyl group, an acetylene group, a butenyl group, an acrylic group, an acrylate group, an acrylamide group, a methacrylic group, a methacrylate group, a methacrylic amide group, a vinyl ether group, a vinylamino group, a silanol group, a group having a small-membered ring (e.g., a cyclopropyl group, a cyclobutyl group, an epoxy group, an oxetane group, a diketene group, and an episulfide group), a lactone group, a lactam group, and a group including a structure of a siloxane derivative. Further, in addition to the above-mentioned groups, combinations of groups capable of forming an ester bond or an amide bond (e.g., an ester group and an amino group, an ester group and a hydroxyl group) can also be used as the crosslinkable group.

Moreover, a carbon atom contained in $Ar^2$ may be directly bound to a carbon atom contained in $Ar^3$, or may be bound to a carbon atom contained in $Ar^3$ via a divalent group, such as -O- and -S-.

Examples of the arylene group include a phenylene group, and examples of the divalent heterocyclic group include a pyridinediyl group. These groups optionally have a substituent.

Examples of the aryl group include a phenyl group and a naphtyl group and these groups optionally have a substituent.

Examples of the monovalent heterocyclic group include a thienyl group, a furyl group, and a pyridyl group and these groups optionally have a substituent.

As the substituents, which the arylene group, the aryl group, the divalent heterocyclic group and the monovalent heterocyclic group may optionally have, an alkyl group, an alkyloxy group, and an aryl group are preferred, and the alkyl group is more preferred from the viewpoint of solubility of the polymer compound. Examples of the alkyl group include a methyl group, an ethyl group, a propyl group, an isopropyl group, a butyl group, an isobutyl group, a tert-butyl group, a sec-butyl group, a pentyl group, a hexyl group, a heptyl group, and an octyl group. Examples of the alkyloxy group include a methoxy group, an ethoxy group, a propyloxy group, an isopropyloxy group, a butyloxy group, an isobutyloxy group, a tert-butyloxy group, a sec-butyloxy group, a pentyloxy group, a hexyloxy group, a pentyloxy group, and a hexyloxy group.

$Ar^1$ to $Ar^4$ are each preferably an arylene group, and more preferably a phenylene group from the viewpoint of the luminance half-decay lifetime of the polymer light-emitting device. $Ar^5$ to $Ar^7$ are each preferably an aryl group, and more preferably a phenyl group from the viewpoint of the luminance half-decay lifetime of the polymer light-emitting device.

From the viewpoint of ease of synthesis of a monomer, m and n are each preferably 0.

Specific examples of the repeating unit represented by the formula (1) include the following repeating units.

[Chem. 2]

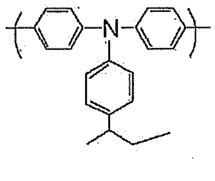
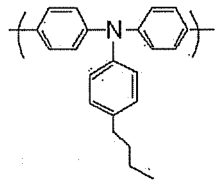
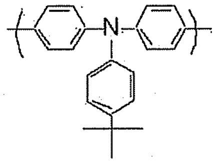
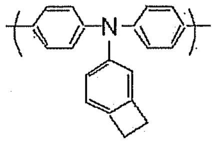

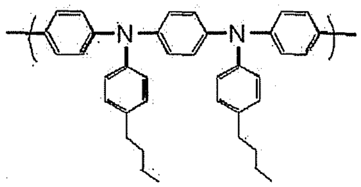
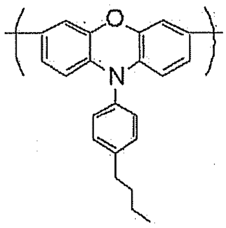
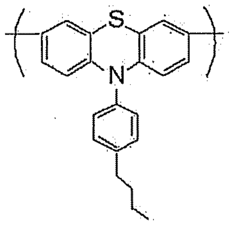

The polymer including the repeating unit including the structure of the aromatic tertiary amine compound represented by the formula (1) may further include other repeating units. Examples of the other repeating units include arylene groups, such as a phenylene group and a fluorenediyl group, and more preferred is the repeating unit represented by the formula:

[Cem.3]

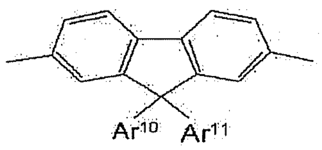

(2)

[Wherein $Ar^{10}$ and $Ar^{11}$ are the same or different and each represent an alkyl group, an aryl group optionally having a substituent or a monovalent heterocyclic group optionally having a substituent.]

In addition, among the polymer compounds including a repeating unit represented by the formula (1), polymer compounds containing a crosslinkable group are more preferable.

As the substituents, which the aryl group and the monovalent heterocyclic group in the formula (2) may optionally have, an alkyl group, an alkyloxy group, and an aryl group are preferred, and an alkyl group is more preferred from the viewpoint of solubility of the polymer compound. Examples of the alkyl group include a methyl group, an ethyl group, a propyl group, an isopropyl group, a butyl group, an isobutyl group, a tert-butyl group, a sec-butyl group, a pentyl group, a hexyl group, a heptyl group, and an octyl group. Examples of the alkyloxy group include a methoxy group, an ethoxy group, a propyloxy group, an isopropyloxy group, a butyloxy group, an isobutyloxy group, a tert-butyloxy group, a sec-butyloxy group, a pentyloxy group, a hexyloxy group, a pentyloxy group, and a hexyloxy group. Examples of the aryl group include a phenyl group, and a naphtyl group, and examples of the monovalent heterocyclic group include a pyridyl group. These groups may have a substituent.

Specific examples of the repeating unit represented by the formula (2) include the following repeating units.

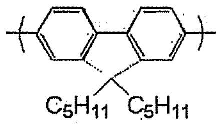
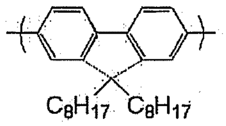
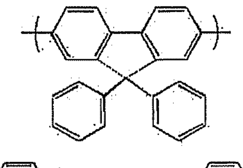
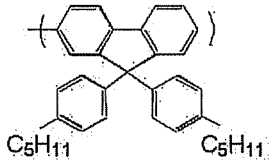
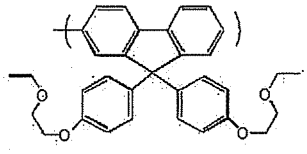
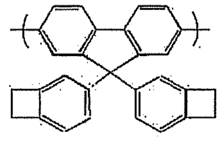

A method for forming the hole transporting layer or the interlayer is not particularly limited, and examples of the method include the same methods as in forming the hole injection layer. Examples of a method for forming a film from a solution include printing methods, such as the above-mentioned spin coating method, casting method, bar coating method, slit coating method, spray coating method, nozzle coating method, gravure printing method, screen printing method, flexo printing method, and ink-jet printing method, and examples for the case of using a sublimating compound material include a vacuum deposition method, a transfer method.

Examples of solvents for use in forming a film from a solution include the solvents recited in the method for forming a film of the hole injection layer.

In forming an organic compound layer, such as an light-emitting layer by an application method after forming the hole transporting layer or the interlayer, if the lower layer is soluble in the solvent contained in the solution of the layer to be applied later, the lower layer can be made insoluble in the solvent by the method similar to that described in the method for producing the film of the hole injection layer.

The film thickness of the hole transporting layer or the interlayer varies in an optimal value depending on a material to be used, and may be selected in such a way that driving voltage and luminous efficiency are moderate, but it is necessary to select such a thickness that at least no pinhole is produced. When the thickness is too large, it is not preferred since the driving voltage of the device becomes high. Therefore, the film thickness of the hole transporting layer and the interlayer is, for example, 1 nm to 1 μm, preferably 2 nm to 500 nm, and moreover preferably 5 nm to 100 nm.

<Light-Emitting Layer>

In the polymer light-emitting device of the present invention, the light-emitting layer is formed by a polymer light-emitting material. As the polymer light-emitting material, conjugated polymer compounds, such as polyfluorene derivatives, poly(p-phenylenevinylene) derivatives, polyphenylene derivatives, poly(p-phenylene) derivatives, polythiophene derivatives, polydialkylfluorene, polyfluorenebenzothiadiazole, and polyalkylthiophene can be suitably used.

Further, the light-emitting layer may contain polymer-based dye compounds, such as perylene-based dyes, coumarin-based dyes, and rhodamine-based dyes, or low molecular dye compounds, such as rubrene, perylene, 9,10-diphenylanthracene, tetraphenylbutadiene, nile red, coumarin 6, and quinacridone. Further, the light-emitting layer may contain naphthalene derivatives, anthracene or derivatives thereof, perylene or derivatives thereof, dyes such as polymethine-based dyes, xanthene-based dyes, coumarin-based dyes, and cyanine-based dyes, metal complexes of 8-hydroxyquinoline or derivatives thereof, aromatic amines, tetraphenylcyclopentadiene or derivatives thereof, or tetraphenylbutadiene or derivatives thereof, and metal complexes emitting phosphorescence, such as tris(2-phenylpyridine)iridium.

Further, the light-emitting layer included in the polymer light-emitting device of the present invention may be composed of a mixed composition of an unconjugated polymer compound [e.g., polyvinylcarbazole, polyvinyl chloride, a polycarbonate, polystyrene, polymethyl methacrylate, polybutyl methacrylate, a polyester, polysulfone, polyphenyleneoxide, polybutadiene, poly(N-vinylcarbazole), a hydrocarbon resin, a ketone resin, a phenoxy resin, a polyamide, ethyl cellulose, ethyl acetate, an ABS resin, a polyurethane, a melamine resin, an unsaturated polyester resin, an alkyd resin, an epoxy resin or a silicone resin; or a polymer containing a carbazole derivative, a triazole derivative, an oxazole derivative, an oxadiazole derivative, an imidazole derivative, a polyarylalkane derivative, a pyrazoline derivative, a pyrazolone derivative, a phenylenediamine derivative, a arylamine derivative, an amino-substituted chalcone derivative, a styrylanthracene derivative, a fluorenone derivative, a hydrazone derivative, a stilbene derivative, a silazane derivative, an aromatic tertiary amine compound, a styrylamine compound, an aromatic dimethylidyne-based compound, a porphyrin-based compound, a polysilane-based compound, a poly(N-vinylcarbazole) derivative, an organic silane derivative] and a light-emitting organic compound, such as the above-mentioned organic dye and metal complex.

Specific examples of such polymer compounds include polyfluorene, or derivatives and copolymers thereof; polyarylene, or derivatives and copolymers thereof; polyarylene vinylene, or derivatives and copolymers thereof; and (co)polymers of aromatic amines or derivatives thereof, which are disclosed in WO 97/09394, WO 98/27136, WO

99/54385, WO 00/22027, WO 01/19834, GB 2340304 A, GB 2348316, US 573636, US 5741921, US 5777070, EP 0707020, Japanese Patent Laid-open Publication No. H9 (1997)-111233, Japanese Patent Laid-open Publication No. H10 (1998)-324870, Japanese Patent Laid-open Publication No. 2000-80167, Japanese Patent Laid-open Publication No. 2001-123156, Japanese Patent Laid-open Publication No. 2004-168999 and Japanese Patent Laid-open Publication No. 2007-162009, and in "Development and Materials of Organic EL Device" (CMC Publishing Co., Ltd., 2006).

Further, specific examples of the low molecular dye compounds include compounds described in Japanese Patent Laid-open Publication No. S57(1982)-51781; and "Data Book on Work Function of Organic Thin Films (2nd edition)" (CMC Publishing Co., Ltd., 2006) and "Development and Materials of Organic EL Device" (CMC Publishing Co., Ltd., 2006).

The above-mentioned materials may be a single component, or may be a composition including a plurality of components. Further, the light-emitting layer may have a single-layer structure composed of one or more of the above-mentioned materials, or may have a multilayer structure composed of a plurality of layers having the same composition or different compositions.

A method for forming the light-emitting layer is not particularly limited, and examples of the method include the same methods as in forming the hole injection layer. Examples of a method for forming a film from a solution include the above-mentioned printing methods, such as the above-mentioned spin coating method, casting method, bar coating method, slit coating method, spray coating method, nozzle coating method, gravure printing method, screen printing method, flexo printing method, and ink-jet printing method and the like, and examples for the case of using a sublimating compound material include a vacuum deposition method and a transfer method.

Examples of solvents for use in forming a film from a solution include the solvents recited in the method for forming a film of the hole injection layer.

In forming an organic compound layer, such as an electron transporting layer by an application method after forming the light-emitting layer, if the lower layer is soluble in the solvent contained in the solution of the layer to be applied later, the lower layer can be made insoluble in the solvent by the method similar to that described in the method for producing the film of the hole injection layer.

The film thickness of the light-emitting layer varies in an optimal value depending on a material to be used, and may be selected in such a way that driving voltage and luminous efficiency are moderate, but it is necessary to select such a thickness that at least no pinhole is produced. That the thickness is too large is not preferred because if so, the driving voltage of the device becomes high. Therefore, the film thickness of the light-emitting layer is, for example, 5 nm to 1 μm, preferably 10 nm to 500 nm, and more preferably 30 nm to 200 nm.

<Electron Transporting Layer or Hole Blocking layer>

As materials composing the electron transporting layer or the hole blocking layer in the polymer light-emitting device of the present invention, publicly known materials can be used, and examples thereof include triazole derivatives, oxazole derivatives, oxadiazole derivatives, imidazole derivatives, fluorenone derivatives, benzoquinone or derivatives thereof, naphthoquinone or derivatives thereof, anthraquinone or derivatives thereof, tetracyanoanthraquinodimethane or derivatives thereof, fluorenone derivatives, diphenyldicyano ethylene or derivatives thereof, diphenoquinone derivatives, anthraquinodimethane derivatives, anthrone derivatives, thiopyrandioxide derivatives, carbodiimide derivatives, fluorenylidene methane derivatives, distyrylpyrazine derivatives, tetracarboxylic acid anhydrides having aromatic rings such as naphthalene and perylene, phthalocyanine derivatives, various metal complexes typified by metal complexes of 8-quinolinol derivatives or metal phthalocyanine, or metal complexes containing benzoxazole or benzothiazole as a ligand, and organic silane derivatives.

Among these, triazole derivatives, oxadiazole derivatives, benzoquinone or derivatives thereof, anthraquinone or derivatives thereof, metal complexes of 8-hydroxyquinoline or derivatives thereof, polyquinoline or derivatives thereof, polyquinoxaline or derivatives thereof, and polyfluorene or derivatives thereof are preferred.

The above-mentioned materials may be a single component, or may be a composition including a plurality of components. Further, the electron transporting layer and the hole blocking layer may have a single-layer structure composed of one or more of the above-mentioned materials, or may have a multilayer structure composed of a plurality of layers having the same composition or different compositions. Further, the materials, which are recited as the materials capable of being used in an electron injection layer, can also be used in the electron transporting layer and the hole blocking layer.

A method for forming the electron transporting layer or the hole blocking layer is not particularly limited, and examples of the method include the same methods as in forming the hole injection layer. Examples of a method for forming a film from a solution include the above-mentioned printing methods, such as the above-mentioned spin coating method, casting method, bar coating method, slit coating method, spray coating method, nozzle coating method, gravure printing method, screen printing method, flexo printing method, and ink-jet printing method, and examples for the case of using a sublimating compound material include a vacuum deposition method and a transfer method.

Examples of solvents for use in forming a film from a solution include the solvents recited in the method for forming a film of the hole injection layer.

In forming an organic compound layer, such as an electron injection layer by an application method after forming the electron transporting layer or the hole blocking layer, if the lower layer is soluble in the solvent contained in the solution of the layer to be applied later, the lower layer can be made insoluble in the solvent by the method similar to that described in the method for producing the film of the hole injection layer.

Film thickness of the electron transporting layer or the hole blocking layer varies in an optimal value depending on a material to be used, and may be selected in such a way that driving voltage and luminous efficiency are moderate, but it is necessary to select such a thickness that at least no pinhole is produced. When the thickness is too large, it is not preferred since the driving voltage of the device becomes high. Therefore, the film thickness of the electron transporting layer or the hole blocking layer is, for example, 1 nm to 1 μm, preferably 2 nm to 500 nm, and more preferably 5 nm to 100 nm.

<Electron Injection Layer>

As materials composing the electron injection layer in the polymer light-emitting device of the present invention, publicly known materials can be used, and examples thereof include triazole derivatives, oxazole derivatives, oxadiazole derivatives, imidazole derivatives, fluorenone derivatives, benzoquinone or derivatives thereof, naphthoquinone or derivatives thereof, anthraquinone or derivatives thereof, tetracyanoanthraquinodimethane or derivatives thereof, fluorenone derivatives, diphenyldicyano ethylene or derivatives thereof, diphenoquinone derivatives, anthraquinodimethane derivatives, anthrone derivatives, thiopyrandioxide derivatives, carbodiimide derivatives, fluorenylidene methane derivatives, distyrylpyrazine derivatives, tetracarboxylic acid anhydrides of aromatic rings such as naphthalene, and perylene, phthalocyanine derivatives, various metal complexes typified by metal complexes of 8-quinolinol derivatives or metal phthalocyanine, or metal complexes containing benzoxazole or benzothiazole as a ligand, and organic silane derivatives.

The above-mentioned materials may be a single component, or may be a composition including a plurality of components. Further, the electron injection layer may have a single-layer structure composed of one or more of the above-mentioned materials, or may have a multilayer structure composed of a plurality of layers having the same composition or different compositions. Further, the materials, which are recited as the materials capable of being used in the electron transporting layer and the hole blocking layer, can also be used in the electron injection layer.

A method for forming the electron injection layer is not particularly limited, and examples of the method include the same methods as in forming the hole injection layer. Examples of a method for forming a film from a solution include the above-mentioned printing methods, such as the above-mentioned spin coating method, casting method, bar coating method, slit coating method, spray coating method, nozzle coating method, gravure printing method, screen printing method, flexo printing method, and ink-jet printing method and the like, and examples for the case of using a sublimating compound material include a vacuum deposition method and a transfer method for the case of using a sublimating compound material. Examples of solvents for use in forming a film from a solution include the solvents recited in the method for forming a film of the hole injection layer.

Film thickness of the electron injection layer varies in an optimal value depending on a material to be used, and may be selected in such a way that driving voltage and luminous efficiency are moderate, but it is necessary to select such a thickness that at least no pinhole is produced. When the thickness is too large, it is not preferred since the driving voltage of the device becomes high. Therefore, the film thickness of the electron injection layer is, for example, 1 nm to 1 μm, preferably 2 nm to 500 nm, and moreover preferably 5 nm to 100 nm.

<Insulating Layer>

The insulating layer having a film thickness of 5 nm or less, which the polymer light-emitting device of the present invention optionally include, has functions of, for example, improving adhesion to the electrode, improving charge (i.e., hole or electron) injection from the electrode, preventing mixing with an adjacent layer. Examples of the material of the insulating layer include metal fluorides, metal oxides, and organic insulating materials (polymethyl methacrylate, etc.). Examples of the polymer light-emitting device provided with an insulating layer having a film thickness of 5 nm or less include a device provided with an insulating layer having a film thickness of 5 nm or less adjacent to the cathode and a device provided with an insulating layer having a film thickness of 5 nm or less adjacent to the anode.

3. Method for Producing Device

The method for producing the polymer light-emitting device of the present invention is not particularly limited and the polymer light-emitting device can be produced by laminating the respective layers successively on the substrate.

Specifically, an anode is disposed on a substrate, thereon layers such as a hole injection layer, a hole transporting layer, and an interlayer are disposed as required, thereon a light-emitting layer is disposed thereon layers such as an electrode transporting layer and an electron injection layer are disposed as required, and thereon a cathode is laminated to produce a polymer light-emitting device.

4. Display

The polymer light-emitting display of the present invention comprises the above-mentioned polymer light-emitting device of the present invention as a pixel unit. An embodiment of the array of the pixel units is not particularly limited and can be an array commonly employed in displays such as television sets, and can be an embodiment in which many pixels are arrayed on a common substrate. In the apparatus of the present invention, the pixels arrayed on a substrate can be formed within a pixel region defined by a bank as required.

The apparatus of the present invention can further include a sealing member on a side opposite to a substrate side of the light-emitting layer so that the light-emitting layer and the like are sandwiched, as required. Further, the apparatus of the present invention can further include any constituent for composing a display, for example, filters such as a color filter, and a fluorescence conversion filter, and circuits, wirings and the like required for driving of pixels, as required.

EXAMPLES

Hereinafter, the present invention will be described in more detail by way of examples and comparative examples, but the present invention is not limited to these examples.

Example 1

Fig. 1 is a schematic sectional view showing a structure of an organic EL device, which is one embodiment of the present invention.

(1-1: Formation of Hole Injection Layer)

A composition for forming a hole injection layer was applied onto a glass substrate 1 provided with an ITO anode 2 thereon by a spin coating method to obtain a coating film with a film thickness of 60 nm.

The substrate provided with the coating film was heated at 200°C for 10 minutes to make the coating film insoluble, and then the substrate was naturally cooled to room temperature to obtain a hole injection layer 3. Here, a PEDOT: PSS aqueous solution (poly(3,4-ethylenedioxythiophene)-polystyrenesulfonic acid, product name "Baytron"), which is available from H.C. Starck-V TECH Ltd., was used for the composition for forming a hole injection layer.

(1-2: Formation of Hole Transporting Layer)

The polymer hole transporting compound and xylene were mixed in such a way that percentage of the polymer hole transporting compound was 0.7% by weight to obtain a composition for forming a hole transporting layer.

Here, the polymer hole transporting compound was synthesized by the method below. In a 1-L three-necked round-bottomed flask equipped with a reflux condenser and an overhead stirrer, 2,7-bis(1,3,2-dioxyborole)-9,9-di(1-octyl)fluorene (3.863g, 7.283mmol), N,N-di(p-bromophenyl)-N-(4-(butan-2-yl)phenyl)amine (3.177g, 6.919mmol) and di (4-bromophenyl)benzocyclobutane amine (156.3 mg, 0.364 mmol) were introduced. Then, methyl trioctylammonium chloride (registered trade name "Aliquat 336", obtained from Sigma-Aldrich Corp.) (2.29g) and subsequently 50 ml of toluene were added. After a $PdCl_2(PPh_3)_2$ catalyst (4.9 mg) was added, the resulting mixture was stirred in an oil bath at 105°C for 15 minutes. An aqueous solution of sodium carbonate (2.0 M, 14 ml) was added, and the reactant was stirred for 16.5 hours in an oil bath at 105°C. Next, phenylboronic acid (0.5 g) was added, and the reactant was stirred for 7 hours. A water layer was removed and an organic layer was washed with 50 ml of water. The organic layer was returned to the reaction flask, and to this, 0.75 g of sodium diethyldithiocarbamate and 50 ml of water were added. The reactant was stirred in an oil bath at 85°C for 16 hours. A water layer was removed, and an organic layer was washed with 100 ml of water three times and passed through a silica gel and basic alumina column. Then, a procedure to precipitate the polymer by adding a toluene solution containing the polymer to methanol was repeated twice, and the resulting polymer was dried at 60°C under vacuum to obtain 4.2 g of the polymer hole transporting compound. The polymer hole transporting compound had a weight average molecular weight (Mw) of 124,000 on the polystyrene equivalent basis and a dispersity (Mw/Mn) of 2.8.

A composition for forming a hole transporting layer was applied onto the hole injection layer obtained in the

above paragraph (1-1) by a spin coating method to obtain a coating film with a film thickness of 20 nm. The substrate provided with the coating film was heated at 190°C for 20 minutes to make the coating film insoluble, and then the substrate was naturally cooled to room temperature to obtain a hole transporting layer 4.

(1-3: Formation of Light-Emitting Layer)

A light-emitting polymer compound and xylene were mixed in such a way that percentage of the light-emitting polymer compound was 1.3% by weight to obtain a composition for forming a light-emitting layer. Here, "Lumation BP361" (trademark) manufactured by SUMATION K.K. was used for the light-emitting polymer compound.

The composition for forming a light-emitting layer was applied onto the hole transporting layer of the substrate having an anode, a hole injection layer and a hole transporting layer, obtained in the above paragraph (1-2), by a spin coating method to obtain a coating film with a film thickness of 65 nm. The substrate provided with the coating film was heated at 130°C for 20 minutes to evaporate a solvent, and then the substrate was naturally cooled to room temperature to obtain a light-emitting layer 5.

(1-4: Formation of Cathode)

A first electrode layer 6 was formed on the light-emitting layer of the substrate having the anode, the hole injection layer, the hole transporting layer and the light-emitting layer, obtained in the above paragraph (1-3), by a vacuum deposition method. The co-deposition method was used as the deposition method for the first electrode layer and NaF which is the first material and Mg which is the second material were used as the vapor deposition source. The first electrode layer had a film thickness of 4 nm. The molar ratio of NaF and Mg in the first electrode layer (mixing molar ratio) was NaF:Mg=8:2. Subsequently, an Ag layer with a film thickness of 80 nm, which is the second electrode layer 7, was formed to obtain a cathode 8.

(1-5: Sealing)

The substrate including lamination obtained in the above paragraph (1-4) was taken out from the vacuum deposition apparatus, and sealed with a sealing glass and a two component epoxy resin (not shown) in a nitrogen atmosphere to obtain a polymer light-emitting device 1.

(1-6: Evaluation)

Voltages of 0 V to 12 V were applied to the device obtained in the above paragraph (1-5), and the luminance level when driven at 4V and the maximum luminous efficiency were measured. Moreover, the luminance half-decay lifetime was measured while applying a constant current at which initial luminance was 2,500 cd/$m^2$. The results of measurement are shown in Table 1.

Example 2

A polymer light-emitting device 2 was prepared in the same manner as in Example 1 except that the mixing molar ratio of NaF and Mg was set at NaF:Mg=2:1 in the first electrode layer. The luminance level when driven at 4V, the maximum luminous efficiency and the luminance half-decay lifetime were measured. The results of measurement are shown in Table 1.

Example 3

A polymer light-emitting device 3 was prepared in the same manner as in Example 1 except that the mixing molar ratio of NaF and Mg was set at NaF:Mg=4:6 in the first electrode layer. The luminance level when driven at 4V, the maximum luminous efficiency and the luminance half-decay lifetime were measured. The results of measurement are shown in Table 1.

Example 4

A polymer light-emitting device 4 was prepared in the same manner as in Example 1 except that the mixing molar ratio of NaF and Mg was set at NaF:Mg=25:75 in the first electrode layer. The luminance level when driven at 4V, the maximum luminous efficiency and the luminance half-decay lifetime were measured. The results of measurement are shown in Table 1.

Example 5

A polymer light-emitting device 5 was prepared in the same manner as in Example 1 except that $Na_2CO_3$, the first material, and Mg, the second material, were used as the vapor deposition source in the first electrode layer, and the film thickness and the mixing molar ratio were set at 4nm and $Na_2CO_3$:Mg=8:2, respectively. The luminance level when driven at 4V, the maximum luminous efficiency and the luminance half-decay lifetime were measured. The results of measurement are shown in Table 1.

Comparative Example 1

A polymer light-emitting device 6 was prepared in the same manner as in Example 1 except that LiF and Ca were used as the vapor deposition source in the first electrode layer, and the film thickness and the mixing molar ratio were set at 4nm and LiF: Ca=2:1, respectively. The luminance level when driven at 4V, the maximum luminous efficiency and the luminance half-decay lifetime were measured. The results of measurement are shown in Table 1.

Comparative Example 2

A polymer light-emitting device 7 was prepared in the same manner as in Example 1 except that merely NaF was used as the vapor deposition source in the first electrode layer, which was not prepared as a mixed layer. The luminance level when driven at 4V, the maximum luminous efficiency and the luminance half-decay lifetime were measured. The results of measurement are shown in Table 1.

[Table 1]

| | | Example | | | | | Comparative Example | |
|---|---|---|---|---|---|---|---|---|
| | | 1 | 2 | 3 | 4 | 5 | 1 | 2 |
| first electrode layer | first material | NaF | NaF | NaF | NaF | $Na_2CO_3$ | LiF | NaF |
| | second material | Mg | Mg | Mg | Mg | Mg | Ca | none |
| | amount of the second material [mol%] | 20 | 33 | 60 | 75 | 20 | 33 | 0 |
| | film thickness [nm] | 4 | 4 | 4 | 4 | 4 | 4 | 4 |
| second electrode layer | material | Ag | Ag | Ag | Ag | Ag | Ag | Ag |
| | film thickness [nm] | 80 | 80 | 80 | 80 | 80 | 80 | 80 |
| Luminance [cd/m$^2$] | | 762 | 1066 | 624 | 383 | 6 | less than 5 ※ | less than 5 ※ |
| maximum efficiency [cd/A] | | 5.9 | 6.2 | 5.5 | 6.0 | 3.2 | - | - |
| Luminance half-decay lifetime [h] | | 18 | 79 | 63 | 35 | 4 | - | - |
| ※: limit of measurement of luminance = 5 cd/m$^2$ | | | | | | | | |

DESCRIPTION OF THE REFERENCE NUMERALS AND SYMBOLS

1... glass substrate,
2... ITO anode,
3... hole injection layer,

4... hole transporting layer,
5... light-emitting layer,
6... first electrode layer,
7... second electrode layer,
8... cathode.

## Claims

1. A polymer light-emitting device comprising a cathode, an anode, and a functional layer containing a polymer compound and a light-emitting layer containing an organic polymer light-emitting compound arranged between the cathode and the anode, wherein
the cathode comprises a first electrode layer and a second electrode layer in this order from the light-emitting layer side,
the first electrode layer comprises a first material and a second material,
the first material is a material which comprises one or more compounds selected from the group consisting of sodium fluoride, potassium fluoride, cesium fluoride, rubidium fluoride and carbonates of alkaline earth metals, and
the second material is a substance which has a reducing action on the first material.

2. The polymer light-emitting device according to claim 1, wherein the first electrode layer consists of the first material and the second material.

3. The polymer light-emitting device according to claim 1 or 2, wherein the first material is sodium fluoride or potassium fluoride and the second material is magnesium, calcium or aluminum.

4. The polymer light-emitting device according to claim 3, wherein the first material is sodium fluoride and the second material is magnesium.

5. The polymer light-emitting device according to claim 1 or 2, wherein the first material is sodium carbonate or potassium carbonate and the second material is magnesium, calcium or aluminum.

6. The polymer light-emitting device according to any of claims 1 to 5, wherein the proportion of the number of moles of the second material to the total number of moles of the materials contained in the first electrode layer is more than 0.20 and not more than 0.60.

7. The polymer light-emitting device according to any of claims 1 to 6, wherein the functional layer contains a polymer compound including a repeating unit represented by the formula:

[Chem. 1]

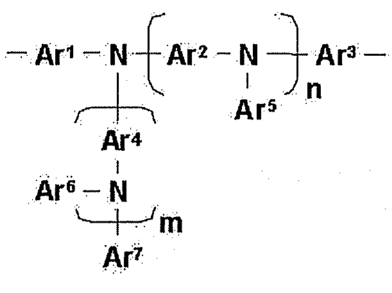

(1)

wherein $Ar^1$, $Ar^2$, $Ar^3$ and $Ar^4$ are the same or different and each represent an arylene group optionally having a substituent or a divalent heterocyclic group optionally having a substituent, $Ar^5$, $Ar^6$ and $Ar^7$ each represent an aryl group optionally having a substituent or a monovalent heterocyclic group optionally having a substituent, n and m are the same or different and each represent 0 or 1, and when n is 0, a carbon atom contained in $Ar^1$ and a carbon atom contained in $Ar^3$ may be bound to each other either directly or via an oxygen atom or a sulfur atom.

8. The polymer light-emitting device according to any of claims 1 to 7, wherein the second electrode layer consists of silver.

1

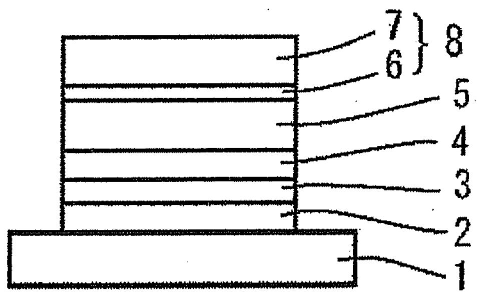

**INTERNATIONAL SEARCH REPORT**

International application No.
PCT/JP2011/050444

A. CLASSIFICATION OF SUBJECT MATTER
*H05B33/26*(2006.01)i, *C08G61/12*(2006.01)i, *H01L51/50*(2006.01)i

According to International Patent Classification (IPC) or to both national classification and IPC

B. FIELDS SEARCHED

Minimum documentation searched (classification system followed by classification symbols)
H05B33/26, C08G61/12, H01L51/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2006-12821 A (General Electric Co.),<br>12 January 2006 (12.01.2006),<br>paragraphs [0016], [0032]<br>& US 2005/0282068 A1 & EP 1610397 A2<br>& KR 10-2006-0046494 A & CN 1722339 A | 1,2<br>3-8 |
| X<br>Y | JP 2004-335468 A (Eastman Kodak Co.),<br>25 November 2004 (25.11.2004),<br>paragraphs [0033], [0051], [0055], [0066], [0067], [0080]<br>& US 2004/0222737 A1 & EP 1475851 A2<br>& KR 10-2004-0095189 A & CN 1551689 A | 1-4<br>5-8 |

☒ Further documents are listed in the continuation of Box C.

☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
17 February, 2011 (17.02.11)

Date of mailing of the international search report
01 March, 2011 (01.03.11)

Name and mailing address of the ISA/
Japanese Patent Office

Facsimile No.

Authorized officer

Telephone No.

Form PCT/ISA/210 (second sheet) (July 2009)

**INTERNATIONAL SEARCH REPORT**

International application No.
PCT/JP2011/050444

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2005-5159 A (Seiko Epson Corp.), 06 January 2005 (06.01.2005), paragraphs [0035] to [0039], [0043], [0047]; fig. 1 (Family: none) | 1-8 |
| Y | G.E.Jabbour et al. 'Aluminum based cathode structure for enhanced electron injection in electroluminescent organic devices', Appl.Phys. Lett., 1998, Vol.73, No.9, pages1185-1187. | 1,2,7 |
| Y | JP 2009-176730 A (Sumitomo Chemical Co., Ltd.), 06 August 2009 (06.08.2009), paragraph [0023] & US 2010/0270544 A & EP 2234459 A1 & WO 2009/084590 A1 | 3-5,7 |
| A | JP 2009-205985 A (Sumitomo Chemical Co., Ltd.), 10 September 2009 (10.09.2009), paragraphs [0097] to [0104], PEDOT:PSS/light emitting polymer/Cs2CO3 and Ag/Ag (Family: none) | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H10199874586 B
- JP 2004311403 A
- JP S63198870257 B
- JP S631988175860 B
- JP H21990135359 B
- JP H21990135361 B
- JP H21990209988 B
- JP H3199137992 B
- JP H31991152184 B
- JP H51993263073 B
- JP H619941972 B
- WO 200552027 A
- JP 2006295203 A
- WO 9709394 A
- WO 9827136 A
- WO 9954385 A
- WO 0022027 A
- WO 0119834 A
- GB 2340304 A
- GB 2348316 A
- US 573636 A
- US 5741921 A
- US 5777070 A
- EP 0707020 A
- JP H91997111233 B
- JP H101998324870 B
- JP 2000080167 A
- JP 2001123156 A
- JP 2004168999 A
- JP 2007162009 A
- JP S57198251781 B


### Non-patent literature cited in the description


- Data Book on Work Function of Organic Thin Films. CMC Publishing Co., Ltd, 2006
- Development and Materials of Organic EL Device. CMC Publishing Co., Ltd, 2006